# EUROPÄISCHE PATENTSCHRIFT

(11) **EP 3 341 746 B1**
(45) Veröffentlichungstag und Bekanntmachung des Hinweises auf die Patenterteilung: **14.08.2019**
(21) Anmeldenummer: 16757215.5
(22) Anmeldetag: 22.08.2016
(51) Int. Cl.: G01R 33/00

(54) **VERFAHREN UND ANORDNUNG ZUR BESTIMMUNG DER QUEREMPFINDLICHKEIT VON MAGNETFELDSENSOREN**
METHOD AND ARRANGEMENT FOR DETERMINING THE TRANSVERSE SENSITIVITY OF MAGNETIC FIELD SENSORS
PROCÉDÉ ET AGENCEMENT DE DÉTERMINATION DE LA SENSIBILITÉ TRANSVERSALE DE DÉTECTEURS DE CHAMP MAGNÉTIQUE

(30) Priorität: 26.08.2015 DE 102015216262
(43) Veröffentlichungstag der Anmeldung: 04.07.2018
(73) Patentinhaber: Fraunhofer-Gesellschaft zur Förderung der angewandten Forschung e.V., 80686 München (DE)
(72) Erfinder: HOHE, Hans-Peter, 91332 Heiligenstadt (DE); PETERS, Volker, 90766 Fürth (DE)
(74) Vertreter: Gagel, Roland
(86) Internationale Anmeldenummer: PCT/EP2016/069777
(87) Internationale Veröffentlichungsnummer: WO 2017/032730

(56) Entgegenhaltungen:
- DE-A1-102006 037 226
- DE-A1-102009 028 956
- DE-A1-102011 004 391

## Beschreibung

### Technisches Anwendungsgebiet

Die vorliegende Erfindung betrifft ein Verfahren sowie eine Anordnung zur Bestimmung der Querempfindlichkeit eines Magnetfeldsensors oder einer Anordnung von Magnetfeldsensoren, die auf einem Substrat angeordnet oder in einem Substrat integriert sind, wobei der Magnetfeldsensor bzw. die Anordnung von Magnetfeldsensoren eine festgelegte Empfindlichkeitsrichtung aufweisen.

Magnetfeldsensoren werden in vielen technischen Anwendungsfeldern eingesetzt, in denen die Stärke und/oder Richtung eines Magnetfeldes an einem Ort bestimmt werden soll. Ein Beispiel ist die Erfassung einer relativen Lage von zwei Objekten zueinander, von denen eines wenigstens einen Magnetfeldsensor und das andere ein Magnetfeld erzeugendes Element trägt.

### Stand der Technik

Magnetfeldsensoren wie bspw. horizontale oder vertikale Hallelemente besitzen häufig eine definierte bzw. festgelegte Empfindlichkeitsrichtung, in der sie in der Regel auch die höchste Messempfindlichkeit aufweisen. Solche Magnetfeldsensoren sind beschrieben in D1 DE102011004391, DE102009 028956 und DE 102006 037226. Mit derartigen Magnetfeldsensoren, auch als einachsige Magnetfeldsensoren bezeichnet, können dann einzelne Komponenten des vektoriellen Magnetfeldes gemessen werden. Aus den Messwerten mehrerer einachsiger Magnetfeldsensoren kann dann bei geeigneter Wahl und Anordnung der Sensoren der komplette Magnetfeldvektor bestimmt werden.

Allerdings können Magnetfeldsensoren, die eine festgelegte Empfindlichkeitsrichtung aufweisen, gegenüber nicht gewünschten Magnetfeldkomponenten querempfindlich sein. Sie zeigen dann auch bei Magnetfeldkomponenten senkrecht zu ihrer Empfindlichkeitsrichtung noch ein wenn auch geringes Messsignal. Diese Querempfindlichkeit kann bei identisch aufgebauten Magnetfeldsensoren auch von Sensor zu Sensor variieren.

Für den Einsatz der Magnetfeldsensoren zur hochgenauen Bestimmung von Magnetfeldkomponenten ist es erforderlich, die Querempfindlichkeit der einzelnen Sensoren zu kennen, um das Messsignal bei Vorliegen von Magnetfeldkomponenten quer zur Empfindlichkeitsrichtung entsprechend korrigieren zu können.

Bisher werden zur Bestimmung der Querempfindlichkeit externe Spulen eingesetzt, die ein senkrecht zur Empfindlichkeitsrichtung verlaufendes Magnetfeld erzeugen. Diese externen Spulen müssen dann genau zu den jeweiligen Magnetfeldsensoren sowie ggf. auch zueinander justiert werden. Dies ist jedoch für den Anwender aufwändig und fehleranfällig.

Die Aufgabe der vorliegenden Erfindung besteht darin, ein Verfahren und eine Anordnung zur Bestimmung der Querempfindlichkeit eines Magnetfeldsensors oder einer Anordnung von Magnetfeldsensoren anzugeben, die eine Bestimmung der Querempfindlichkeit mit hoher Genauigkeit und ohne aufwändige Justageanforderungen für den Anwender ermöglichen.

### Darstellung der Erfindung

Die Aufgabe wird mit den Verfahren und den Sensoranordnungen der Patentansprüche 1 und 4 gelöst. Das Verfahren und die Sensoranordnung der Patentansprüche 1 und 4 beziehen sich dabei auf die Bestimmung der Querempfindlichkeit einer Anordnung mehrerer Magnetfeldsensoren, die eine festgelegte Empfindlichkeitsrichtung aufweist. Vorteilhafte Ausgestaltungen des Verfahrens nach Anspruch 1 sowie der Sensoranordnung nach Anspruch 4 sind Gegenstand der abhängigen Patentansprüche.

Bei dem vorgeschlagenen Verfahren zur Bestimmung der Querempfindlichkeit eines Magnetfeldsensors, der eine festgelegte Empfindlichkeitsrichtung aufweist und auf einem Substrat angeordnet oder in einem Substrat integriert ist, werden ein oder mehrere elektrische Leiter auf das Substrat aufgebracht und/oder in das Substrat integriert, der oder die bei Stromfluss ein Magnetfeld erzeugen. Hierbei kann es sich bspw. um eine einfache Leiterbahn, um einen zu einer Spule geformten elektrischen Leiter oder auch um einen Elektromagneten handeln. Der eine oder die mehreren elektrischen Leiter werden dabei so angeordnet und ausgebildet, dass sie am Ort des Magnetfeldsensors ein oder mehrere Magnetfelder erzeugen, das oder die entweder ausschließlich eine Magnetfeldkomponente senkrecht zu der festgelegten Empfindlichkeitsrichtung aufweisen oder von dem oder denen lediglich eine Magnetfeldkomponente senkrecht zu der festgelegten Empfindlichkeitsrichtung zu einem Messsignal oder kombinierten Messsignal des Magnetfeldsensors beiträgt. Bei dem kombinierten Messsignal kann es sich beispielsweise um ein aus zeitlich getrennten Mess- bzw. Einzelsignalen gebildetes Summensignal handeln. Es wird dann ein Stromfluss bekannter Größe durch den einen oder die mehreren elektrischen Leiter erzeugt, durch den ein oder mehrere Magnetfelder mit der Magnetfeldkomponente senkrecht zu der festgelegten Empfindlichkeitsrichtung am Ort des Magnetfeldsensors erzeugt werden. Das durch diese Magnetfeldkomponente in dem Magnetfeldsensor hervorgerufene Messsignal wird erfasst, um daraus die Querempfindlichkeit des Magnetfeldsensors zu erhalten.

Das vorgeschlagene Verfahren lässt sich auch bei einer Anordnung von Magnetfeldsensoren durchführen, die ein aus den Messsignalen der Magnetfeldsensoren kombiniertes Ausgangssignal liefert und eine festgelegte Empfindlichkeitsrichtung aufweist. Die Magnetfeldsensoren sind dabei wiederum auf einem Substrat angeordnet und/oder in einem Substrat integriert. Auch in diesem Fall werden ein oder mehrere elektrische Leiter auf das Substrat aufgebracht und/oder in das Substrat integriert, die bei Stromfluss ein Magnetfeld erzeugen. Der oder die elektrischen Leiter werden dabei so angeordnet und ausgebildet, dass sie an den Orten der Magnetfeldsensoren jeweils ein oder mehrere Magnetfelder erzeugen, von dem oder denen lediglich eine Magnetfeldkomponente senkrecht zu der festgelegten Empfindlichkeitsrichtung zum Ausgangssignal der Anordnung beiträgt. Das durch die Magnetfeldkomponente bei einem definierten Stromfluss durch den einen oder die mehreren elektrischen Leiter senkrecht zu der festgelegten Empfindlichkeitsrichtung in der Anordnung hervorgerufene Ausgangssignal wird wiederum erfasst, um daraus die Querempfindlichkeit der Anordnung zu erhalten.

Bei beiden Anwendungen müssen der eine oder die mehreren elektrischen Leiter selbstverständlich so angeordnet sein, dass das am Ort der Magnetfeldsensoren bei einem Stromfluss durch den oder die Leiter erzeugte Magnetfeld eine ausreichende Stärke aufweist, und damit die Querempfindlichkeit des Magnetfeldsensors bzw. der Anordnung von Magnetfeldsensoren bestimmen zu können. Weiterhin muss die Größe dieses Magnetfeldes am Ort der Magnetfeldsensoren bei dem gewählten Stromfluss bekannt sein. Diese kann durch entsprechende Vormessungen bestimmt oder auch aus der Geometrie und der Größe des Stromflusses berechnet werden. Bei der Bestimmung der Querempfindlichkeit der Anordnung von Magnetfeldsensoren kann die Kombination der Messsignale der einzelnen Magnetfeldsensoren im einfachsten Fall eine Addition der Messsignale der Einzelsensoren darstellen.

Eine der beiden vorgeschlagenen Sensoranordnungen weist dementsprechend wenigstens einen Magnetfeldsensor mit einer festgelegten Empfindlichkeitsrichtung auf. Der wenigstens eine Magnetfeldsensor ist dabei zusammen mit einem oder mehreren elektrischen Leitern auf einem Substrat angeordnet und/oder in einem Substrat integriert, der bzw. die bei Stromfluss ein oder mehrere Magnetfelder erzeugen. Dabei kann der Magnetfeldsensor bspw. in das Substrat integriert und der eine oder die mehreren elektrischen Leiter auf das Substrat aufgebracht sein. Der oder die elektrischen Leiter sind dabei so angeordnet und ausgebildet, dass sie am Ort des Magnetfeldsensors bei einem Stromfluss ein oder mehrere Magnetfelder erzeugen können, das oder die entweder ausschließlich eine Magnetfeldkomponente senkrecht zu der festgelegten Empfindlichkeitsrichtung aufweisen oder von dem oder denen lediglich eine Magnetfeldkomponente senkrecht zu der festgelegten Empfindlichkeitsrichtung zu einem Messsignal oder kombinierten Messsignal des Magnetfeldsensors beiträgt.

Die zweite Sensoranordnung umfasst entsprechend mehrere Magnetfeldsensoren, aus deren Messsignalen ein kombiniertes Ausgangssignal erzeugt werden kann, für das die Sensoranordnung eine festgelegte Empfindlichkeitsrichtung aufweist. Die Magnetfeldsensoren sind wiederum zusammen mit einem oder mehreren elektrischen Leitern auf einem Substrat angeordnet und/oder in einem Substrat integriert, die bei Stromfluss ein oder mehrere Magnetfelder erzeugen. Der eine oder die mehreren elektrischen Leiter sind so angeordnet und ausgebildet, dass sie an den Orten der Magnetfeldsensoren jeweils ein oder mehrere Magnetfelder erzeugen können, von dem oder denen lediglich eine Magnetfeldkomponente senkrecht zu der festgelegten Empfindlichkeitsrichtung zum Ausgangssignal beiträgt.

Durch die Integration bzw. Aufbringung der ein oder mehreren elektrischen Leiter zur Erzeugung des Magnetfeldes, mit dem die Querempfindlichkeit des Magnetfeldsensors oder der Anordnung von Magnetfeldsensoren bestimmt werden soll, in bzw. auf das Substrat mit dem oder den Magnetfeldsensoren ist keine externe Spule oder externe Magnetfelderzeugung zur Bestimmung der Querempfindlichkeit mehr notwendig. Die elektrischen Leiter können bspw. mit Hilfe von lithographischen Techniken sehr genau hinsichtlich ihrer Geometrie und Anordnung festgelegt und auf Halbleitersubstrate aufgebracht werden. Damit kann ein Magnetfeld genau festlegbarer Stärke am Ort der Magnetfeldsensoren erzeugt werden, das die entsprechende Magnetfeldkomponente exakt senkrecht zur Empfindlichkeitsrichtung des Magnetfeldsensors bzw. der Anordnung von Magnetfeldsensoren aufweist. Dies ermöglicht die Bestimmung der Querempfindlichkeit mit hoher Genauigkeit, so dass diese auch entsprechend genau korrigiert werden kann. Der Anwender muss keinerlei Justageschritte für die Bestimmung der Querempfindlichkeit mehr durchführen. Die Bestimmung kann dabei entweder im Vorfeld vor einer Magnetfeldmessung mit den Magnetfeldsensoren oder auch während der Messung durchgeführt werden, wobei in beiden Fällen das Magnetfeld zur Bestimmung der Querempfindlichkeit vorzugsweise als magnetisches Wechselfeld erzeugt wird. Dadurch lässt sich der Anteil am Messsignal, der durch diese senkrecht zur Empfindlichkeitsrichtung verlaufende Magnetfeldkomponente hervorgerufen wird, von anderen Anteilen des Messsignals trennen.

In einer vorteilhaften Ausgestaltung zur Bestimmung der Querempfindlichkeit eines einzelnen Magnetfeldsensors wird der elektrische Leiter als Planarspule so ausgebildet und angeordnet, dass der Magnetfeldsensor bei Draufsicht auf die Spule im Zentrum der Spule angeordnet ist. Bei einem Magnetfeldsensor, der seine festgelegte Empfindlichkeitsrichtung parallel zur Substratoberfläche aufweist, wird damit durch die Spule am Ort des Sensors ausschließlich eine Magnetfeldkomponente erzeugt, die senkrecht zu dieser festgelegten Empfindlichkeitsrichtung zeigt.

Eine vergleichbare Ausgestaltung lässt sich auch für eine Anordnung von Magnetfeldsensoren realisieren. Bei dieser Ausgestaltung wird der elektrische Leiter ebenfalls als Spule, insbesondere als Planarspule, ausgebildet. Die Magnetfeldsensoren der Anordnung sind dann so innerhalb der Spule angeordnet, dass sich Signalanteile von Magnetfeldkomponenten des durch die Spule erzeugten Magnetfeldes, die am Ort der Magnetfeldsensoren parallel zu der festgelegten Empfindlichkeitsrichtung verlaufen, im kombinierten Ausgangsignal auslöschen. Anstelle einer einzelnen Spule können dabei auch mehrere Spulen, bspw. in koaxialer Anordnung, zum Einsatz kommen, die dann jeweils ein gemeinsames Gebiet umschließen, in dem die Magnetfeldsensoren in der oben angegebenen Weise angeordnet sind.

In einer anderen vorteilhaften Ausgestaltung ist der Magnetfeldsensor zwischen mehreren elektrischen Leitern angeordnet, durch die ein entsprechendes Magnetfeld am Ort des Magnetfeldsensors erzeugt wird. Bei exakt symmetrischer Anordnung des Magnetfeldsensors zwischen zwei Leitern wird erreicht, dass mit dem Magnetfeldsensor, wenn dieser wiederum eine festgelegte Empfindlichkeitsrichtung parallel zur Substratoberfläche aufweist, lediglich eine Magnetfeldkomponente senkrecht zu der festgelegten Empfindlichkeitsrichtung zu einem Messsignal des Magnetfeldsensors beiträgt. Dies kann bei nicht symmetrischer Anordnung auch durch unterschiedliche Ströme durch die beiden elektrischen Leiter erreicht werden. Hierbei können die beiden Leiter auch zeitlich nacheinander bzw. alternierend jeweils mit Strom beaufschlagt werden. Die durch den Magnetfeldsensor gelieferten Messsignale für jedes der beiden zeitlich nacheinander erzeugten Magnetfelder werden dann zu einem kombinierten Messsignal summiert, zu dem dann lediglich die Magnetfeldkomponente senkrecht zu der festgelegten Empfindlichkeitsrichtung beiträgt. Dies gilt in gleicher Weise bei einer Anordnung des Magnetfeldsensors zwischen zwei vorzugsweise planaren elektrischen Spulen und lässt sich auch auf eine Anordnung von mehr als zwei elektrischen Leitern oder Spulen übertragen. Weiterhin lässt sich die zeitlich versetzte Erzeugung der Magnetfelder auch bei der Bestimmung der Querempfindlichkeit einer Anordnung von Magnetfeldsensoren anwenden, die ein aus den Messsignalen der Magnetfeldsensoren kombiniertes Ausgangssignal liefert und eine festgelegte Empfindlichkeitsrichtung aufweist. In diesem Fall wird dann das Ausgangssignal aus entsprechend zeitlich versetzten Messungen gebildet.

### Kurze Beschreibung der Zeichnungen

Das vorgeschlagene Verfahren und die zugehörigen Anordnungen werden nachfolgend anhand von Ausführungsbeispielen in Verbindung mit den Zeichnungen nochmals näher erläutert. Hierbei zeigen:
- Fig. 1: ein Beispiel für eine Ausgestaltung der vorgeschlagenen Sensoranordnung zur Bestimmung der Querempfindlichkeit eines Magnetfeldsensors;
- Fig. 2: ein zweites Beispiel für eine Ausgestaltung der vorgeschlagenen Sensoranordnung zur Bestimmung der Querempfindlichkeit eines Magnetfeldsensors;
- Fig. 3: ein Beispiel für eine Ausgestaltung der vorgeschlagenen Sensoranordnung zur Bestimmung der Querempfindlichkeit einer Anordnung aus mehreren Magnetfeldsensoren; und
- Fig. 4: ein weiteres Beispiel für eine Ausgestaltung der vorgeschlagenen Sensoranordnung zur Bestimmung der Querempfindlichkeit eines Magnetfeldsensors.

### Wege zur Ausführung der Erfindung

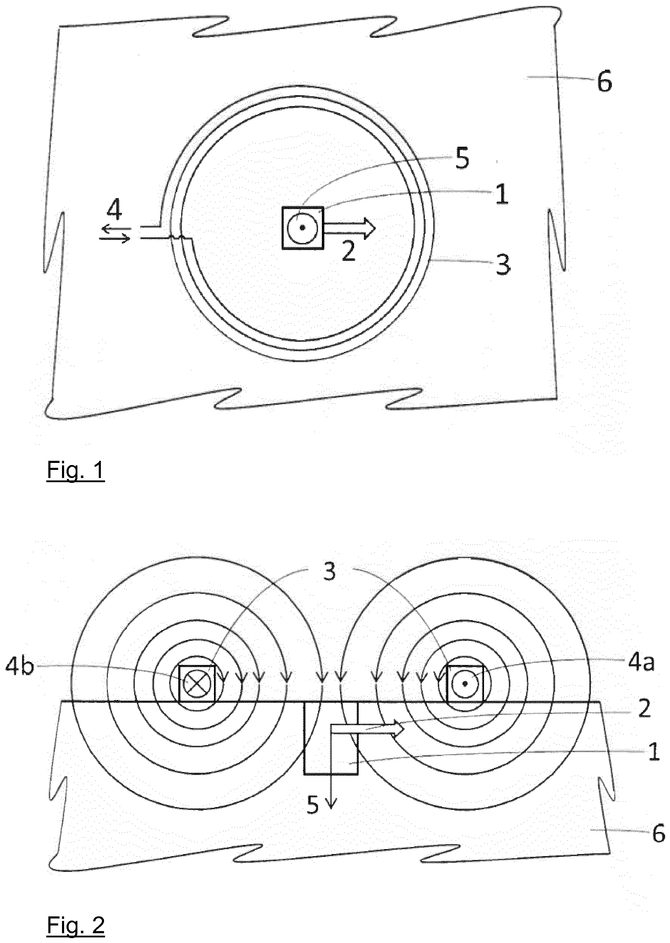

Figur 1 zeigt ein erstes Beispiel für eine Ausgestaltung der vorgeschlagenen Sensoranordnung zur Bestimmung der Querempfindlichkeit eines einzelnen Magnetfeldsensors 1. Der Magnetfeldsensor 1, bspw. ein Hallsensor, ist dabei in ein Substrat 6 integriert, und weist eine festgelegte Empfindlichkeitsrichtung 2 auf. Er soll damit Magnetfeldkomponenten detektieren, die in dieser Empfindlichkeitsrichtung 2 auftreten. Zur möglichst genauen Bestimmung dieser Magnetfeldkomponenten in Empfindlichkeitsrichtung 2 ist es erforderlich, dass eine eventuelle Querempfindlichkeit des Magnetfeldsensors 1 auf Magnetfeldkomponenten senkrecht zur Empfindlichkeitsrichtung 2 bekannt ist, damit das Messsignal bei Vorliegen derartiger Magnetfeldkomponenten senkrecht zur Empfindlichkeitsrichtung 2 geeignet korrigiert werden kann.

Zur Bestimmung der Querempfindlichkeit ist im vorliegenden Beispiel auf der Oberfläche des Substrates 6 ein elektrischer Leiter 3 in Form einer Planarspule um den Magnetfeldsensor 1 herum angeordnet. Der Magnetfeldsensor 1 befindet sich dabei in Draufsicht auf das Substrat 6 im Zentrum dieser Spule. Zur Bestimmung der Querempfindlichkeit des Magnetfeldsensors 1 wird ein Stromfluss 4 einer bekannten Größe durch die Spule geleitet. Das dadurch erzeugte Magnetfeld weist am Ort des Magnetfeldsensors 1 eine Magnetfeldkomponente 5 auf, die exakt senkrecht zur Empfindlichkeitsrichtung 2 des Magnetfeldsensors gerichtet ist. An dieser Stelle tritt ausschließlich die senkrechte Magnetfeldkomponente 5 auf. Das durch diese Magnetfeldkomponente 5 im Magnetfeldsensor 2 hervorgerufene Messsignal wird erfasst und entspricht der Querempfindlichkeit des Magnetfeldsensors auf die Magnetfeldkomponente 5 bekannter Stärke.

Figur 2 zeigt ein weiteres Beispiel für eine Bestimmung der Querempfindlichkeit eines Magnetfeldsensors 1, der in ein Substrat 6 integriert ist. Im Beispiel der Figur 2 ist ein Schnittbild senkrecht zur Oberfläche des Substrates 6 dargestellt. Der in dem Substrat 6 integrierte Sensor 1, bspw. ein Hallsensor, weist wiederum eine definierte Empfindlichkeitsrichtung 2 parallel zur Oberfläche des Substrates 6 auf. In diesem Beispiel wird das Magnetfeld zur Bestimmung der Querempfindlichkeit durch zwei getrennte elektrische Leiter 3 erzeugt, die parallel zueinander verlaufen und zwischen denen der Magnetfeldsensor 1 mittig angeordnet ist. Beide elektrischen Leiter 3 werden jeweils mit einem entgegen gerichteten Stromfluss 4a bzw. 4b beaufschlagt, wie dies in der Figur 2 angedeutet ist. Der Stromfluss und somit die durch den Stromfluss erzeugten magnetischen Felder sind bekannt und in der Figur durch Magnetfeldlinien angedeutet. Am Ort des Sensors 1 entsteht dabei ein kombiniertes Magnetfeld mit einer Magnetfeldkomponente 5, die senkrecht zur Empfindlichkeitsrichtung 2 des Magnetfeldsensors 1 verläuft. Durch den Magnetfeldsensor 1 wird bei einer entsprechenden Querempfindlichkeit lediglich ein Messsignal aufgrund dieser senkrechten Magnetfeldkomponente 5 erzeugt. Die am Ort des Magnetfeldsensors 1 parallel zur Empfindlichkeitsrichtung verlaufenden Magnetfeldkomponenten des durch die beiden Leiter 3 erzeugten Magnetfeldes heben sich im Messsignal des Magnetfeldsensors 1 in diesem Beispiel gegenseitig auf. Auch auf diese Weise kann somit die Querempfindlichkeit des Magnetfeldsensors 1 bestimmt werden.

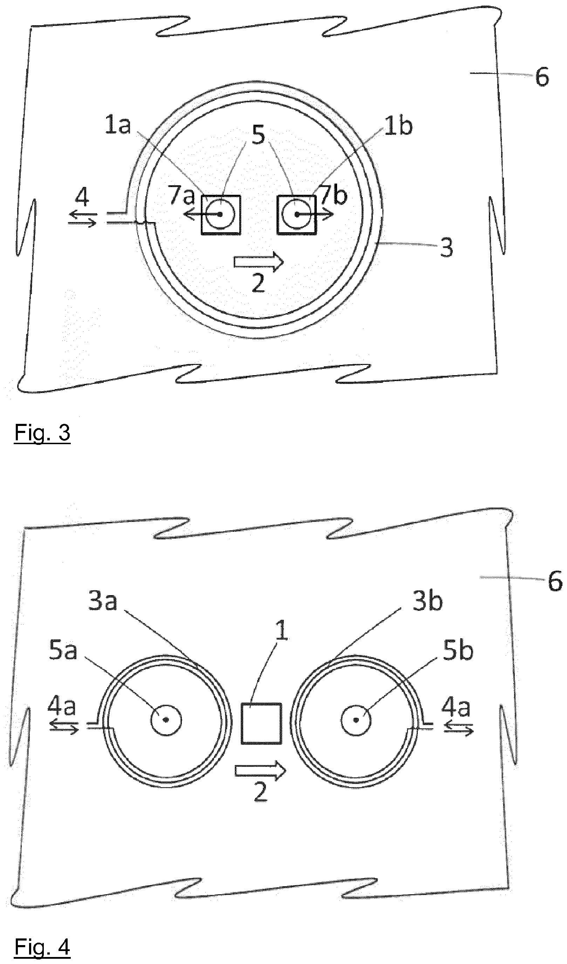

Figur 3 zeigt ein Beispiel einer Sensoranordnung aus zwei Magnetfeldsensoren 1a, 1b, die als Ausgangssignal die Summe der Messsignale der beiden Einzelsensoren liefert und eine festgelegte Empfindlichkeitsrichtung 2 aufweist. Zur Bestimmung der Querempfindlichkeit wird auch hier ein zu einer Planarspule geformter elektrischer Leiter 3 eingesetzt, der auf die Oberfläche des Substrates 6 aufgebracht ist. Die beiden Magnetfeldsensoren 1a, 1b weisen hierbei jeweils eine festgelegte Empfindlichkeitsrichtung auf, die der Empfindlichkeitsrichtung 2 der gesamten Sensoranordnung entspricht, und sind in das Substrat 6 integriert. Die Spule ist dabei relativ zu den Einzelsensoren 1a, 1b so angeordnet, dass diese bei Draufsicht auf die Spule punktsymmetrisch bezüglich des Zentrums der Spule liegen. Bei einem Stromfluss 4 durch die Spule werden am Ort jedes Magnetfeldsensors 1a, 1b sowohl Magnetfeldkomponenten 5 senkrecht zur Oberfläche des Substrats 6 als auch Magnetfeldkomponenten 7a, 7b parallel zur Oberfläche des Substrats 6 erzeugt, wie dies in der Figur 3 angedeutet ist. Im Summensignal dieser Sensoranordnung, in dem die Messsignale der beiden Magnetfeldsensoren 1a, 1b durch Addition kombiniert werden, werden die parallel zur Oberfläche gerichteten Magnetfeldkomponenten 7a, 7b kompensiert, so dass nur noch die senkrecht zur Oberfläche gerichteten Magnetfeldkomponenten 5 gemessen und damit die Querempfindlichkeit der Sensoranordnung bestimmt wird.

Figur 4 zeigt schließlich ein weiteres Beispiel einer Sensoranordnung zur Bestimmung der Querempfindlichkeit eines Magnetfeldsensors. In diesem Beispiel werden zwei zu einer Spule strukturierte elektrische Leiter 3a, 3b eingesetzt und beidseitig des Magnetfeldsensors 1 auf dem Substrat angeordnet. Der Magnetfeldsensor 1 ist wiederum in das Substrat 6 integriert und weist eine Empfindlichkeitsrichtung 2 parallel zur Oberfläche des Substrates auf. Durch die beiden Spulen werden Magnetfelder mit im Zentrum der Spulen senkrechten Magnetfeldkomponenten 5a, 5b erzeugt, die am Ort des Magnetfeldsensors 1 nicht nur senkrecht zur Empfindlichkeitsrichtung 2 verlaufende Magnetfeldkomponenten sondern auch parallel dazu verlaufende Magnetfeldkomponenten aufweisen. Diese kompensieren sich im Messsignal wie bei der Ausgestaltung der Figur 2 gegenseitig. Wird anstelle des einen Magnetfeldsensors 1 eine Anordnung mehrerer Magnetfeldsensoren eingesetzt, so können die parallel verlaufenden Magnetfeldkomponenten bei geeigneter Anordnung der Magnetfeldsensoren bzw. der Spulen in ähnlicher Weise wie bei Figur 3 auch durch die Kombination der Messsignale der Einzelsensoren im Ausgangssignal kompensiert werden. Die Ströme 4a, 4b durch die beiden Spulen können, müssen aber nicht identisch sein.

Selbstverständlich kann die Geometrie der für die Magnetfelderzeugung eingesetzten elektrischen Leiter sowie deren Anordnung relativ zu dem einen oder den mehreren Magnetfeldsensoren auch deutlich von den Ausgestaltungen abweichen, die in den vorangegangenen Ausführungsbeispielen erläutert wurden. Wesentlich hierbei ist lediglich, dass mit diesen elektrischen Leitern ein Magnetfeld am Ort des jeweiligen Magnetfeldsensors erzeugt werden kann, über den die Querempfindlichkeit des Magnetfeldsensors oder der Anordnung von Magnetfeldsensoren messbar ist.

### Bezugszeichenliste

- 1, 1a, 1b: Magnetfeldsensor mit definierter Empfindlichkeitsrichtung
- 2: definierte Empfindlichkeitsrichtung
- 3, 3a, 3b: elektrischer Leiter
- 4, 4a, 4b: Stromfluss
- 5: Magnetfeldkomponente senkrecht zur Empfindlichkeitsrichtung
- 6: Substrat
- 7a, 7b: Magnetfeldkomponente parallel zur Empfindlichkeitsrichtung

## Patentansprüche

1. Verfahren zur Bestimmung der Querempfindlichkeit einer Anordnung von Magnetfeldsensoren (1a, 1b), die auf einem Substrat (6) angeordnet und/oder in einem Substrat (6) integriert sind, wobei die Anordnung ein aus Messsignalen der Magnetfeldsensoren (1a, 1b) kombiniertes Ausgangsignal liefert und eine festgelegte Empfindlichkeitsrichtung (2) aufweist, bei dem
- ein oder mehrere Spulen (3), die bei Stromfluss ein Magnetfeld erzeugen, auf das Substrat (6) aufgebracht und/oder in das Substrat (6) integriert werden,
- wobei die eine oder die mehreren Spulen (3) so angeordnet und ausgebildet werden, dass sie ein gemeinsames Gebiet umschließen, in dem die Magnetfeldsensoren (1a, 1b) der Anordnung von Magnetfeldsensoren angeordnet sind und sie an den Orten der Magnetfeldsensoren (1a, 1b) jeweils ein oder mehrere Magnetfelder erzeugen, von dem oder denen lediglich eine Magnetfeldkomponente (5) senkrecht zu der festgelegten Empfindlichkeitsrichtung (2) zum Ausgangssignal der Anordnung beiträgt, und
- das durch die Magnetfeldkomponente (5) senkrecht zu der festgelegten Empfindlichkeitsrichtung (2) in der Anordnung hervorgerufene Ausgangssignal erfasst wird, um die Querempfindlichkeit der Anordnung zu erhalten.

2. Verfahren nach Anspruch 1,
**dadurch gekennzeichnet,**
**dass** das durch die Magnetfeldkomponente (5) senkrecht zu der festgelegten Empfindlichkeitsrichtung (2) in der Anordnung hervorgerufene Ausgangssignal bei unterschiedlichem Stromfluss durch die eine oder die mehreren Spulen (3) erfasst wird, um die Querempfindlichkeit bei unterschiedlicher Stärke der Magnetfeldkomponente (5) senkrecht zu der festgelegten Empfindlichkeitsrichtung (2) zu erfassen.

3. Verfahren nach Anspruch 1 oder 2,
**dadurch gekennzeichnet,**
**dass** die eine oder die mehreren Spulen (3) als Planarspulen ausgebildet werden.

4. Sensoranordnung mit mehreren Magnetfeldsensoren (1a, 1b), mit der ein aus Messsignalen der Magnetfeldsensoren (1a, 1b) kombiniertes Ausgangsignal erzeugt werden kann, für das sie eine festgelegte Empfindlichkeitsrichtung aufweist, bei der
die Magnetfeldsensoren (1a, 1b) auf einem Substrat (6) angeordnet und/oder in einem Substrat integriert sind und
eine oder mehrere Spulen (3), die bei Stromfluss ein Magnetfeld erzeugen, auf dem Substrat (6) angeordnet und/oder in das Substrat (6) integriert sind,
wobei die eine oder die mehreren Spulen (3) so angeordnet und ausgebildet sind, dass sie an den Orten der Magnetfeldsensoren (1a, 1b) bei Stromfluss jeweils ein oder mehrere Magnetfelder erzeugen können, von dem oder denen lediglich eine Magnetfeldkomponente (5) senkrecht zu der festgelegten Empfindlichkeitsrichtung (2) zum Ausgangssignal beiträgt, und
wobei die eine oder die mehreren Spulen ein gemeinsames Gebiet umschließen, in dem zwei oder mehr Magnetfeldsensoren (1a, 1b) so angeordnet sind, dass sich Signalanteile von Magnetfeldkomponenten des durch die Spule(n) erzeugten Magnetfeldes, die am Ort der Magnetfeldsensoren (1a, 1b) parallel zu der festgelegten Empfindlichkeitsrichtung (2) verlaufen, im kombinierten Ausgangsignal auslöschen.

5. Sensoranordnung nach Anspruch 4,
**dadurch gekennzeichnet,**
**dass** die eine oder die mehreren Spulen (3) als Planarspulen ausgebildet sind.

6. Sensoranordnung nach Anspruch 4 oder 5,
**dadurch gekennzeichnet,**
**dass** die Magnetfeldsensoren (1, 1a, 1b) Hallsensoren sind.

## Claims

1. Method for determining the transverse sensitivity of an arrangement of magnetic field sensors (1a, 1b) which are arranged on a substrate (6) and/or integrated in a substrate (6), wherein the arrangement returns an output signal combined from measurement signals of the magnetic field sensors (1a, 1b) and has a defined direction of sensitivity (2), in which
- one or more coils (3), which generate a magnetic field upon the application of a current flow are applied on the substrate (6) and/or integrated in the substrate (6),
- wherein the one or more coils (3) are arranged and embodied in such manner that they enclose a common area in which the magnetic field sensors (1a, 1b) of the arrangement of magnetic field sensors are disposed, and generate one or more magnetic fields at the locations of the magnetic field sensors (1a, 1b), of which only one magnetic field component (5) perpendicular to the defined direction of sensitivity (2) contributes to the output signal of the arrangement, and
- the output signal induced in the arrangement by the magnetic field component (5) perpendicular to the defined direction of sensitivity (2) is captured to obtain the transverse sensitivity of the arrangement.

2. Method according to Claim 1,
**characterized in that**
the output signal generated in the arrangement by the magnetic field component (5) perpendicular to the defined direction of sensitivity (2) is captured for a different current flow through the one or more coils (3), in order to capture the transverse sensitivity for different strengths of the magnetic field component (5) perpendicular to the defined direction of sensitivity (2).

3. Method according to Claim 1 or 2,
**characterized in that**
the one or more coils (3) are embodied as planar coils.

4. Sensor arrangement with multiple magnetic field sensors (1a, 1b), with which an output signal combined from measurement signals of the magnetic field sensors (1a, 1b) can be created, for which it has a defined direction of sensitivity, in which
the magnetic field sensors (1a, 1b) are arranged on a substrate (6) and/or integrated in a substrate and
one or more coils (3), which generate a magnetic field when a current flow is applied, are arranged on the substrate (6) and/or integrated in the substrate (6),
wherein the one or more coils (3) are arranged and embodied in such manner that they can each generate one or more magnetic fields at the locations of the magnetic field sensors (1a, 1b) when current flows are applied, of which only one magnetic field component (5) perpendicular to the defined direction of sensitivity (2) contributes to the output signal, and
wherein the one or more coils enclose a common area in which two or more magnetic field sensors (1a, 1b) are arranged in such manner that signal portions of magnetic field components of the magnetic field generated by the coil(s) which extend parallel to the defined direction of sensitivity (2) at the location of the magnetic field sensors (1a, 1b) cancel each other out in the combined output signal.

5. Sensor arrangement according to Claim 4,
**characterized in that**
the one or more coils (3) is/are embodied as planar coils.

6. Sensor arrangement according to Claim 4 or 5,
**characterized in that**
the magnetic field sensors (1, 1a, 1b) are Hall sensors.

## Revendications

1. Procédé de détermination de la sensibilité transversale d'un système de capteurs de champ magnétique (1a, 1b), qui sont disposés sur un substrat (6) et/ou intégrés dans un substrat (6), sachant que le système fournit un signal initial combiné à partir de signaux de mesure des capteurs de champ magnétique (1a, 1b) et comporte une direction de sensibilité déterminée (2), pour lequel
- une ou plusieurs bobines (3), qui produisent un champ magnétique avec un flux de courant, sont montées sur le substrat (6) et/ou intégrées dans le substrat (6),
- sachant qu'une ou plusieurs bobines (3) sont disposées et constituées de telle sorte qu'elles entourent une zone commune, dans laquelle sont disposés les capteurs de champ magnétique (1a, 1b) du système de capteurs de champ magnétique et elles produisent respectivement un ou plusieurs champs magnétiques aux emplacements des capteurs de champ magnétique (1a, 1b), à partir duquel ou desquels seul un composant de champ magnétique (5) contribue au signal initial du système perpendiculairement à la direction de sensibilité déterminée (2), et
- le signal initial causé par le composant de champ magnétique (5) perpendiculairement à la direction de sensibilité déterminée (2) dans le système est saisi pour obtenir la sensibilité transversale du système.

2. Procédé selon la revendication 1, **caractérisé en ce que** le signal initial causé par le composant de champ magnétique (5) perpendiculairement à la direction de sensibilité déterminée (2) dans le système est saisi avec un flux de courant différent par une ou plusieurs bobines (3) pour saisir la sensibilité transversale avec une intensité différente du composant de champ magnétique (5) perpendiculairement à la direction de sensibilité déterminée (2).

3. Procédé selon la revendication 1 ou 2, **caractérisé en ce qu'**une ou plusieurs bobines (3) sont constituées sous la forme de bobines planaires.

4. Système de capteurs avec plusieurs capteurs de champ magnétique (1a, 1b), avec lequel un signal initial combiné à partir de signaux de mesure des capteurs de champ magnétique (1a, 1b) peut être produit, pour lequel il comporte une direction de sensibilité déterminée, pour lequel les capteurs de champ magnétique (1a, 1b) sont disposés sur un substrat (6) et/ou intégrés dans un substrat, et une ou plusieurs bobines (3), qui produisent un champ magnétique avec un flux de courant, sont disposées sur le substrat (6) et/ou intégrées dans le substrat (6), sachant qu'une ou plusieurs bobines (3) sont disposées ou constituées de telle sorte qu'elles peuvent produire respectivement aux emplacements des capteurs de champ magnétique (1a, 1b) un ou plusieurs champs magnétique avec un flux de courant, à partir duquel ou desquels seul un composant de champ magnétique (5) contribue au signal initial perpendiculairement à la direction de sensibilité déterminée (2), et sachant qu'une ou plusieurs bobines entourent une zone commune, dans laquelle deux ou plusieurs capteurs de champ magnétique (1a, 1b) sont disposés de telle sorte que des parties de signal des composants de champ magnétique du champ magnétique produit par la/les bobine(s), passant à l'emplacement des capteurs de champ magnétique (1a, 1b) parallèlement à la direction de sensibilité déterminée (2), s'éliminent en signal initial combiné.

5. Procédé selon la revendication 4, **caractérisé en ce qu'**une ou plusieurs bobines (3) sont constituées sous la forme de bobines planaires.

6. Procédé selon la revendication 4 ou 5, **caractérisé en ce que** les capteurs de champ magnétique (1, 1a, 1b) sont des capteurs Hall.
